# EUROPEAN PATENT SPECIFICATION

(11) **EP 3 404 227 B1**
(45) Date of publication and mention of the grant of the patent: **02.10.2019**
(21) Application number: 18172681.1
(22) Date of filing: 16.05.2018
(51) Int. Cl.: F01N 5/02, H01L 35/30

(54) **THERMOELECTRIC GENERATOR FOR AN EXHAUST SYSTEM OF AN INTERNAL COMBUSTION ENGINE**
THERMOELEKTRISCHER GENERATOR FÜR EIN ABGASSYSTEM EINES VERBRENNUNGSMOTORS
GÉNÉRATEUR THERMOÉLECTRIQUE POUR UN SYSTÈME D'ÉCHAPPEMENT D'UN MOTEUR À COMBUSTION INTERNE

(30) Priority: 16.05.2017 IT 201700052891
(43) Date of publication of application: 21.11.2018
(73) Proprietor: Magneti Marelli S.p.A., 20011 Corbetta (MI) (IT)
(72) Inventor: BRIGNONE, Mauro, 10124 TORINO (IT)
(74) Representative: Maccagnan, Matteo

(56) References cited:
- EP-A1- 2 498 309
- WO-A1-2007/026432
- DE-A1-102011 005 206

## Description

### TECHNICAL FIELD

The present invention relates to a thermoelectric generator (also referred to as "TEG") for an exhaust system of an internal combustion engine.

### PRIOR ART

In the continuous search for increasing the efficiency of internal combustion engines, it has recently been proposed to use part of the heat possessed by the exhaust gases (which would otherwise be completely dispersed in the atmosphere through the exhaust system) to generate electricity by using thermoelectric cells.

It has therefore been proposed to dispose along the exhaust system a thermoelectric generator provided with a plurality of solid state thermoelectric cells, each of which has a hot side that is exposed to the exhaust gases to be heated by the exhaust gases (which can have a temperature of 250-750°C depending on the area of the exhaust system in which the thermoelectric generator is arranged) and a cold side (opposite the hot side) that is constantly cooled by a cooling fluid (which is strictly isolated from the exhaust gases and is generally composed of water that transfers heat to the external environment by circulating also through a radiator).

A solid state thermoelectric cell is able to convert heat into electrical energy (through the Seebeck effect) when there is a difference in temperature between its hot side and its cold side. The effectiveness of electricity generation is guaranteed by ensuring that the temperature of the cold side of the thermoelectric cell remains adequately lower than the temperature of the hot side, being therefore necessary to provide for a constant cooling of the cold side.

By way of example, patent applications WO2011107282 US2011083831A1, EP2765285A1, US2014305481A1, US2015128590A1 and US2016155922A1 describe thermoelectric generators for an exhaust system of an internal combustion engine.

Patent applications DE102011005206A1 and EP2498309A1 also describe thermoelectric generators for an exhaust system of an internal combustion engine.

### DESCRIPTION OF THE INVENTION

The object of the present invention is to provide a thermoelectric generator for an exhaust system of an internal combustion engine, wherein said thermoelectric generator allows achieving a high energy efficiency in the generation of electrical energy and, at the same time, is easy and inexpensive to manufacture.

According to the present invention, it is provided a thermoelectric generator for an exhaust system of an internal combustion engine as claimed in the appended claims.

### BRIEF DESCRIPTION OF THE DRAWINGS

The present invention will now be described with reference to the accompanying drawings showing an example of a non-limiting embodiment, in which:
Figure 1 is a perspective view of a thermoelectric generator for an exhaust system of an internal combustion engine manufactured in accordance with the present invention;
Figure 2 is a perspective view of the thermoelectric generator of Figure 1 lacking an inlet pipe and an outlet pipe;
• Figures 3, 4 and 5 are different perspective views of the thermoelectric generator of Figure 1 lacking some parts for clarity's sake;
• Figure 6 is a front view of the thermoelectric generator of Figure 1 lacking some parts for clarity's sake;
• Figure 7 is a side view of the thermoelectric generator of Figure 1 lacking some parts for clarity's sake;
Figure 8 is a sectional view taken along the line VIII-VIII of the thermoelectric generator of Figure 1;
Figure 9 is a sectional view taken along the line IX-IX of the thermoelectric generator of Figure 1; and
• Figures 10 to 13 are different perspective views of a variant of the thermoelectric generator of Figure 1 lacking some parts for clarity's sake.

### PREFERRED EMBODIMENTS OF THE INVENTION

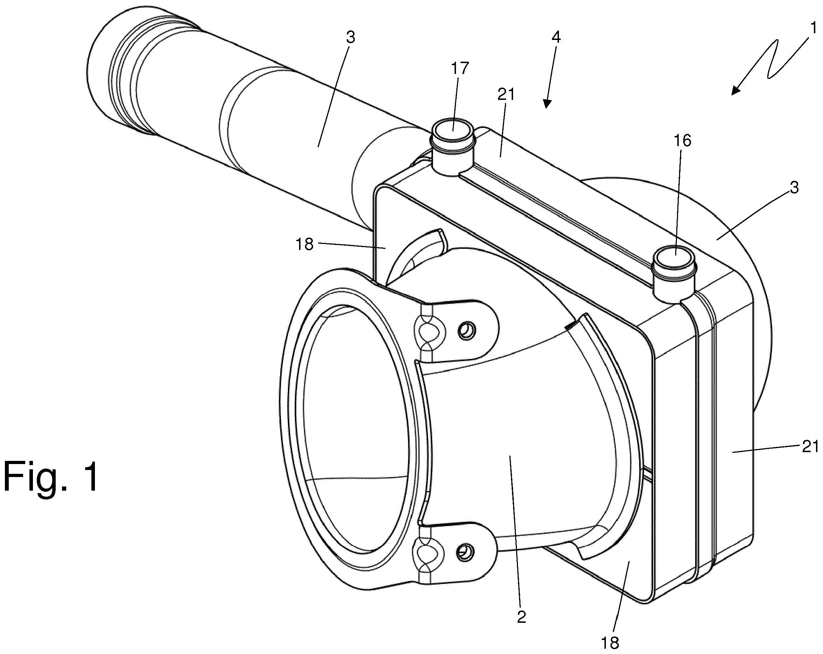

In Figure 1, the reference number 1 indicates as a whole a thermoelectric generator (namely a device able to convert part of the heat possessed by the exhaust gases into electric energy) for an exhaust system of an internal combustion engine.

The thermoelectric generator 1 can be arranged along the exhaust system in different areas. For example, the thermoelectric generator 1 can be arranged immediately downstream of the exhaust manifold (and, if present, of the compression turbine) of the internal combustion engine, it can be arranged between the catalyst and the particulate filter or it can be arranged downstream of the particulate filter.

The exhaust system of the internal combustion engine comprises an exhaust gas inlet pipe 2 through which the hot exhaust gases coming from the internal combustion engine are fed towards the thermoelectric generator 1 (i.e. the inlet pipe 2 ends in the thermoelectric generator 1) and an exhaust outlet pipe 3 through which the exhaust gases coming out of the thermoelectric generator 1 are fed into the external environment (i.e. the outlet pipe 3 originates from the thermoelectric generator 1).

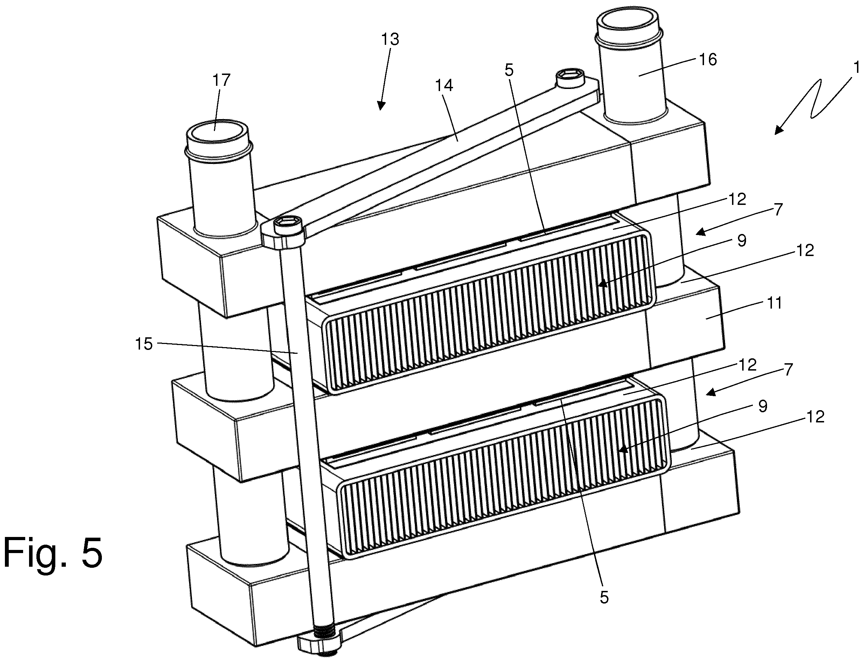

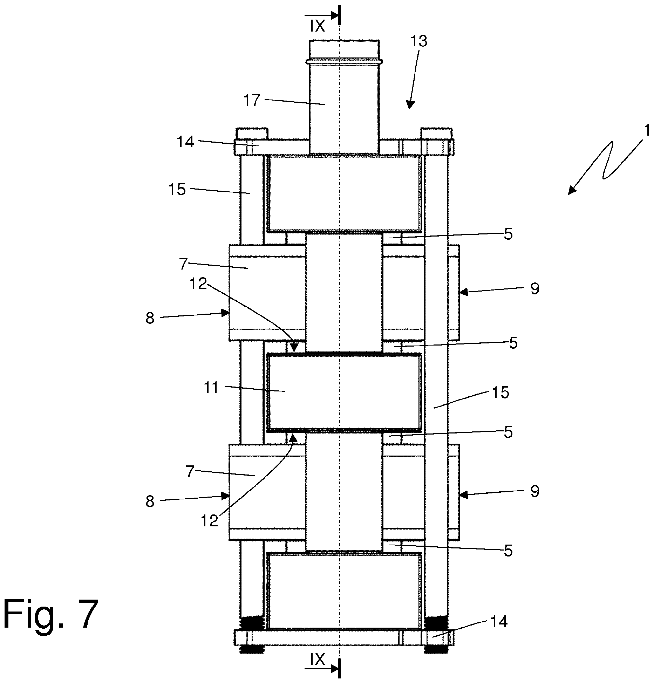

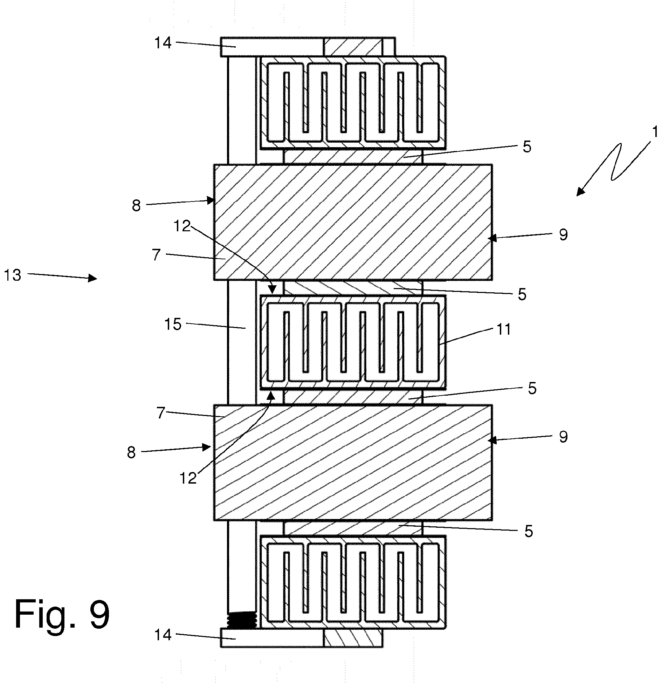

The thermoelectric generator 1 comprises a parallelepiped-shaped closed casing 4 housing four solid state thermoelectric cells 5 (shown in Figures 5, 6, 7 and 9), each of which is able to convert the heat into electrical energy (through the Seebeck effect) when there is a difference in temperature between its hot side and its cold side. The efficiency of electricity generation is guaranteed by ensuring that the temperature of the cold side of each thermoelectric cell 5 remains adequately lower than the temperature of the hot side and it is therefore necessary to provide both a constant heating of the hot side and a constant cooling of the cold side.

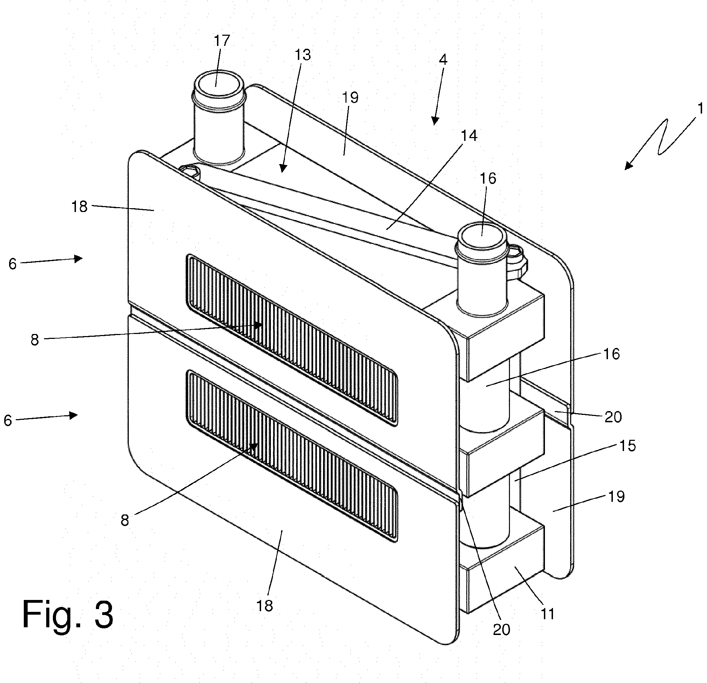

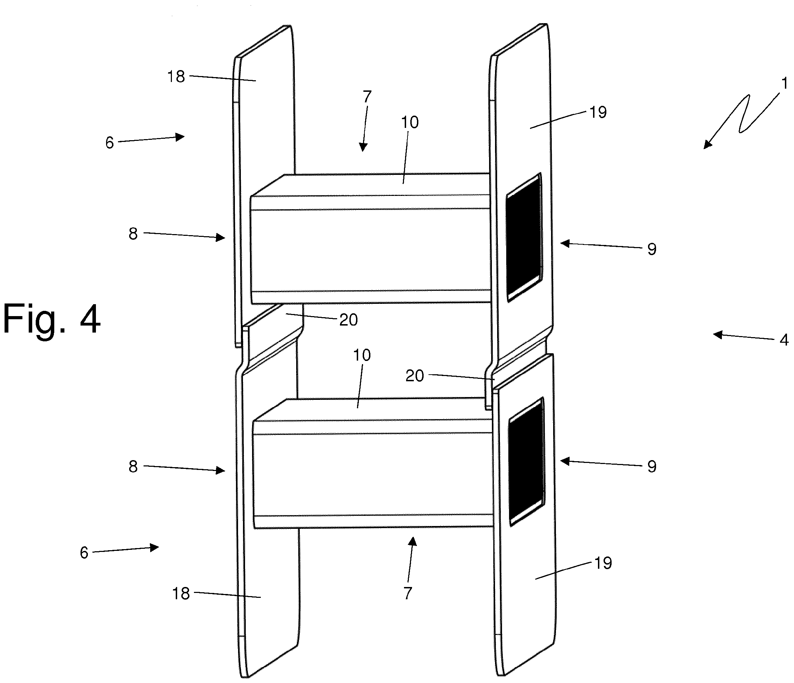

According to what shown in Figures 3 and 4, the thermoelectric generator 1 comprises two superimposed feeding elements 6, each of which is provided with a tubular duct 7 flown through by the exhaust gases. The tubular duct 7 of each feeding element 6 has a parallelepiped shape (i.e. it has a rectangular-shaped cross section) and develops along a feeding direction (rectilinear in the shown embodiment) between an inlet opening 8 (through which the exhaust gases enter) and an outlet opening 9 (through which the exhaust gases leave).

The tubular duct 7 of each feeding element 6 has a pair of parallel and opposite heat exchange walls 10, which are also parallel to the feeding direction, wherein the hot side of a corresponding thermoelectric cell 5 rests against each heat exchange wall 10.

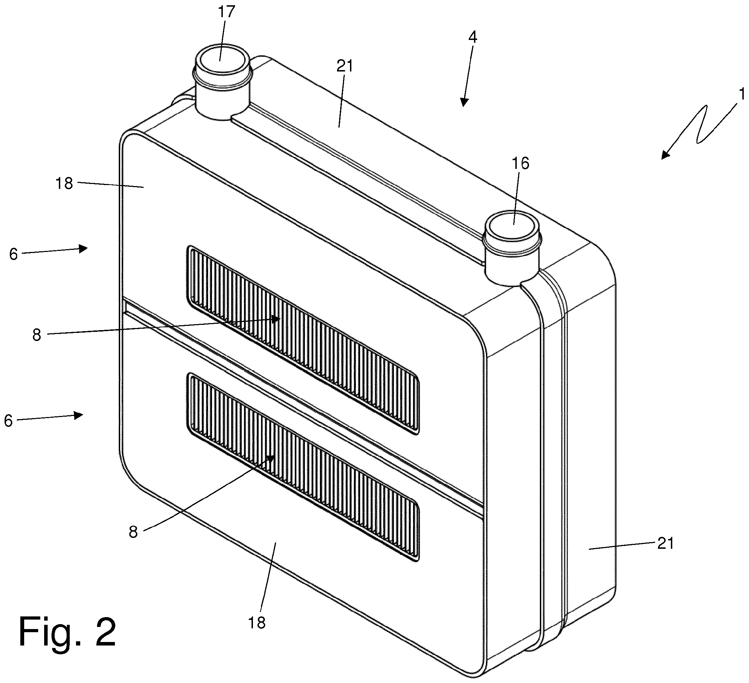

Preferably and as shown in Figures 2-6, the duct 7 of each feeding element 6 is internally provided with a plurality of fins, which are parallel to the feeding direction and whose function is increasing the heat exchange surface.

As shown in Figures 3, 5, 6, 7 and 9, the thermoelectric generator 1 comprises three cooling elements 11, each of which subtracts heat; the three cooling elements 11 are alternated with the ducts 7 of the feeding elements 6. In particular, each cooling element 11 has a parallelepiped shape and has a pair of parallel and opposite heat exchange walls 12, which are also parallel to the heat exchange walls 10 of the ducts 7, namely parallel to the feeding direction of the ducts 7. The cold sides of corresponding thermoelectric cells 5 rest against some heat exchange walls 12. In this way, in each thermoelectric cell 5, the hot side rests against the heat exchange wall 10 of a corresponding duct 7 and the cold side rests against the heat exchange wall 12 of a corresponding cooling element 11.

In other words, the ducts 7 of the two feeding elements 6 are alternated with the three cooling elements 11 so that each exchange wall 10 of a duct 7 faces a corresponding heat exchange wall 12 of a cooling element 11. A thermoelectric cell 5 is interposed between each heat exchange wall 10 of a duct 7 and the corresponding heat exchange wall 12 of a cooling element 11 (the hot side of the thermoelectric cell 5 rests against the heat exchange wall 10 of the duct 7 and the cold side of the thermoelectric cell 5 rests against the heat exchange wall 12 of the cooling element 11).

According to a preferred embodiment, the thermoelectric generator 1 comprises a fixing system 13 (better shown in Figures 5, 6 and 7) which locks in clamping manner the feeding elements 6, the cooling elements 11 and the thermoelectric cells 5. In particular, the fixing system 13 comprises a lower plate 14, an upper plate 14 and at least a pair of tie bars 15, which are perpendicular to the plates 14 and connect the plates 14.

According to a preferred but non-limiting embodiment, a sheet of graphite (or other similar material) is interposed between the sides of each thermoelectric cell 5 and the corresponding heat exchange wall 10 and 12, graphite being a thermally conductive and easily deformable material (i.e. a "soft" material). The function of each sheet of graphite is to improve the contact (i.e. to increase the contact surface) between one side of the thermoelectric cell 5 and the corresponding heat exchange wall 10 or 12 to increase the heat exchange, thus evenly filling any possible surface irregularities.

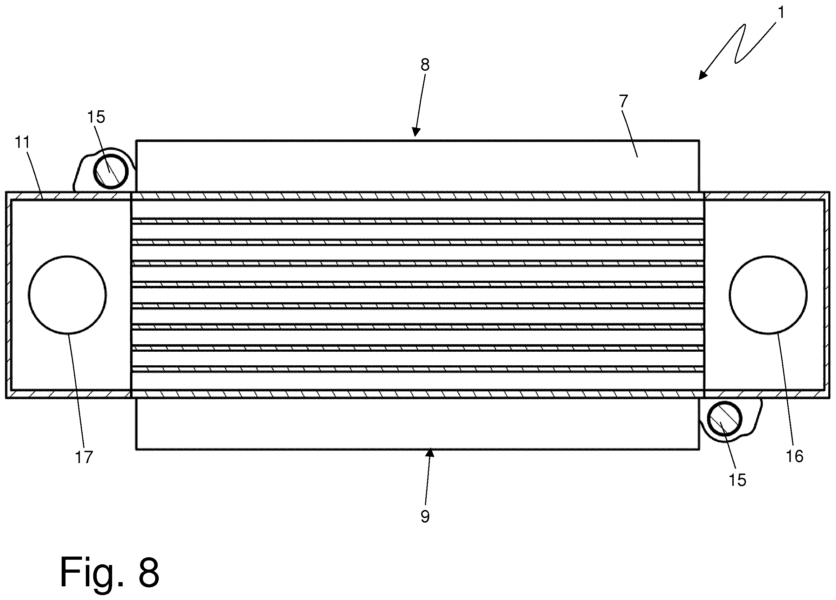

As shown in Figures 5-8, the thermoelectric generator 1 comprises a cooling system, which in turn comprises the cooling elements 11, which can be flown through by a cooling fluid (typically water, possibly added with additives), a delivery pipe 16, which is arranged beside the ducts 7 and is hydraulically connected to each cooling element 11 for conveying the cooling fluid towards the cooling elements 11, and a return pipe 17, which is arranged beside the ducts 7 on the opposite side with respect to the delivery pipe 16 and is hydraulically connected to each cooling element 11 to receive the cooling fluid from the cooling elements 11. Preferably, the delivery pipe 16 and the return pipe 17 pass through each cooling element 11; that is, the delivery pipe 16 and the return pipe 17 are through pipes passing through each cooling element 11.

As better shown in Figures 3 and 4, each feeding element 6 has a front wall 18, which is rigidly integral with the duct 7, is perpendicular to the duct 7 (namely perpendicular to the feeding direction) and to the heat exchange walls 10 and has a central inlet opening 8.

Moreover, each feeding element 6 has a rear wall 19, which is rigidly integral with the duct 7, is perpendicular to the duct 7 (namely perpendicular to the feeding direction) and to the heat exchange walls 10, is parallel and opposite the front wall 18, and has a central outlet opening 9. Basically, and as well shown in Figure 4, each feeding element 6 has an "H" shape, in which the front wall 18 and the rear wall 19 make up the two bars and the duct 7 makes up the connection portion between the two bars.

According to a preferred embodiment better shown in Figure 4, the lower edge of the rear wall 19 of the upper feeding element 6 and the upper edge of the front wall 18 of the lower feeding element 6 are flared to provide a mechanical interlocking when the two feeding elements 6 are superimposed. More generally, the upper edge or the lower edge of the front wall 18 or of the rear wall 19 of each feeding element 6 is flared to provide a mechanical interlocking when the two feeding elements 6 are superimposed.

In particular, the rear wall 19 of the upper feeding element 6 and the front wall 18 of the lower feeding element 6 each have a recess 20 formed by means of an S-shaped deformation. Moreover, in the upper feeding element 6, the front wall 18 has a lower height than the rear wall 19 and in the lower feeding element 6, the rear wall 19 has a lower height than the front wall 18. In other words, the upper feeding element 6 is completely identical to the lower feeding element 6 but has an opposite orientation (i.e. is arranged "upside down") so that a recess 20 is arranged between the two front walls 18, whereas the other recess 20 is arranged between the two rear walls 19.

The front walls 18 of the two feeding elements 6 receive the inlet pipe 2, which conveys the exhaust gases towards the two inlet openings 8, and the rear walls 19 of the two feeding elements 6 receive the outlet pipe 3, which receives the exhaust gases from the two outlet openings 9.

As shown in Figures 1 and 2, the thermoelectric generator 1 comprises an annular panel 21, which is oriented perpendicularly to the front and rear walls 18 and 19 of the feeding elements 6, and is connected to the front and rear walls 18 and 19 of the feeding elements 6, and delimits a closed volume together with the front and rear walls 18 and 19 of the feeding elements 6. In other words, the casing 4 containing the ducts 7, the thermoelectric cells 5 and the cooling elements 11 is formed by the front and rear walls 18 and 19 of the feeding elements 6 and by the annular panel 21, which connects the front and rear walls 18 and 19 of the feeding elements 6.

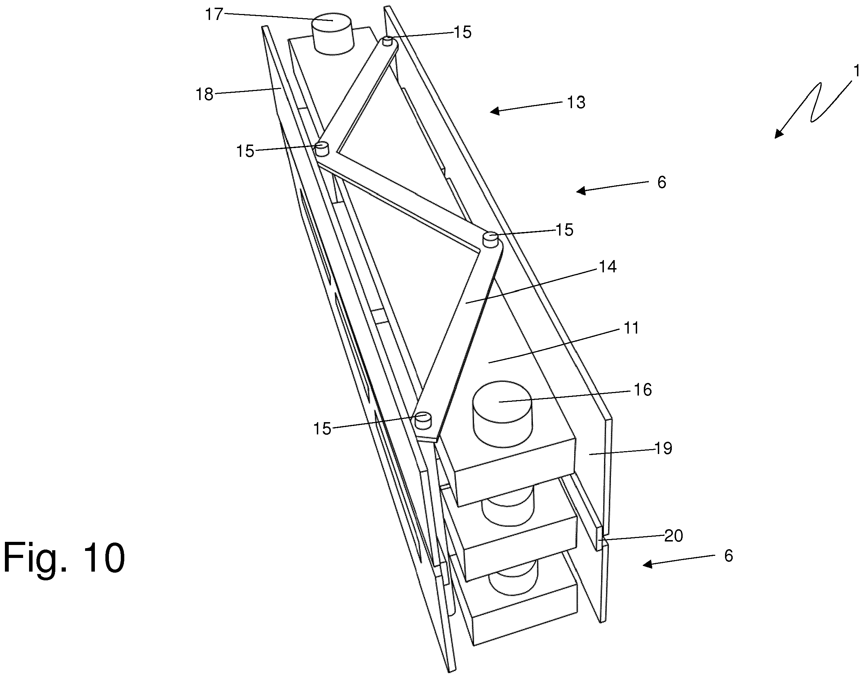

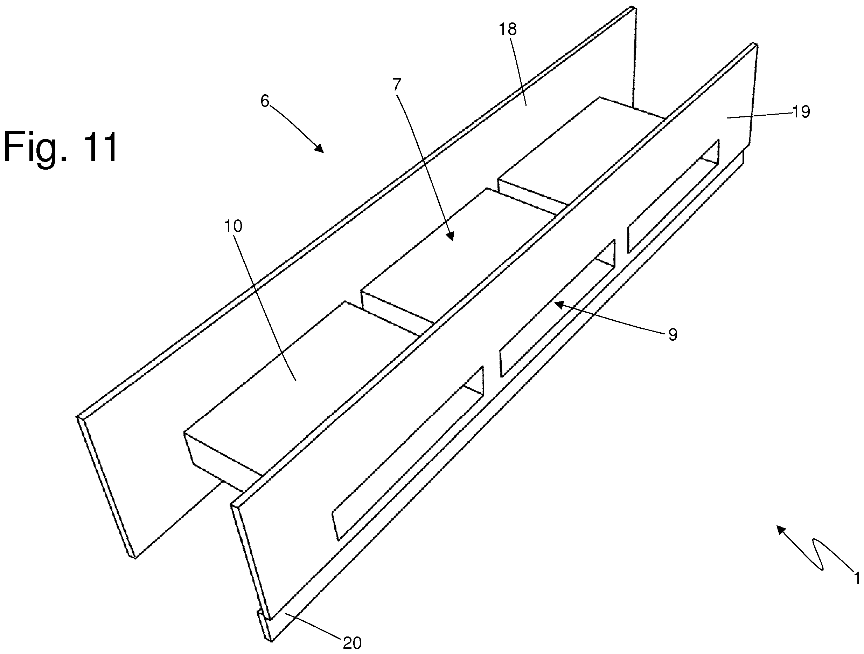

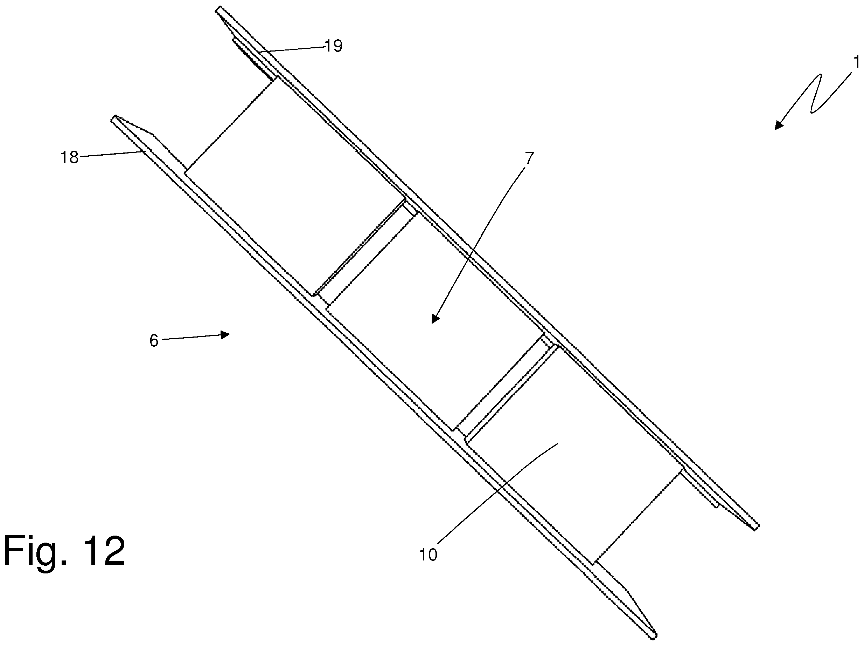

In the embodiment shown in Figures 1-9, each feeding element 6 comprises a single duct 7, which extends over the entire width of the feeding element 6. In the variant shown in Figures 10-13, each feeding element 6 comprises several parallel, adjacent and separate ducts 7 (in particular three parallel, adjacent and separate ducts 7), each of which extends from a corresponding inlet opening 8 to a corresponding outlet opening 9 (therefore the front wall 18 of each feeding element 6 has three inlet openings 8 and the rear wall 19 of each feeding element 6 has three adjacent outlet openings 9). The presence of several ducts 7 allows inserting a further intermediate tie bar 15 of the fixing system 13 between two adjacent ducts 7 (namely, in the free gap between two adjacent ducts 7. In this way, the fixing system 13 does not comprise only two end tie bars 15 (as in the embodiment shown in Figures 1-9), but may also comprise intermediate tie bars 15 (shown in Figure 10), which allow applying a more even pressure along the whole length (when the pressure is more even, it is also possible to increase the total pressure which, being better distributed, does not excessively stress some limited areas that could otherwise collapse). In other words, to subject the thermoelectric cells 5 to a greater and more even pressure, the ducts 7 through which the exhaust gases flow are divided into several separate parts (at least two), thus being able to insert the intermediate tie bars 15 along the width of the feeding element 6 between the parallel and adjacent ducts 7. The plates 14 have a broken (or zigzag) shape to connect all the tie bars 15.

The embodiment shown in Figures 1 to 9 provides two superimposed feeding elements 6 (supporting a total of two ducts 7), three cooling elements 11 alternated with the two feeding elements 6 and twelve thermoelectric cells 5, each of which is interposed between a corresponding duct 7 of a feeding element 6 and a corresponding cooling element 11.

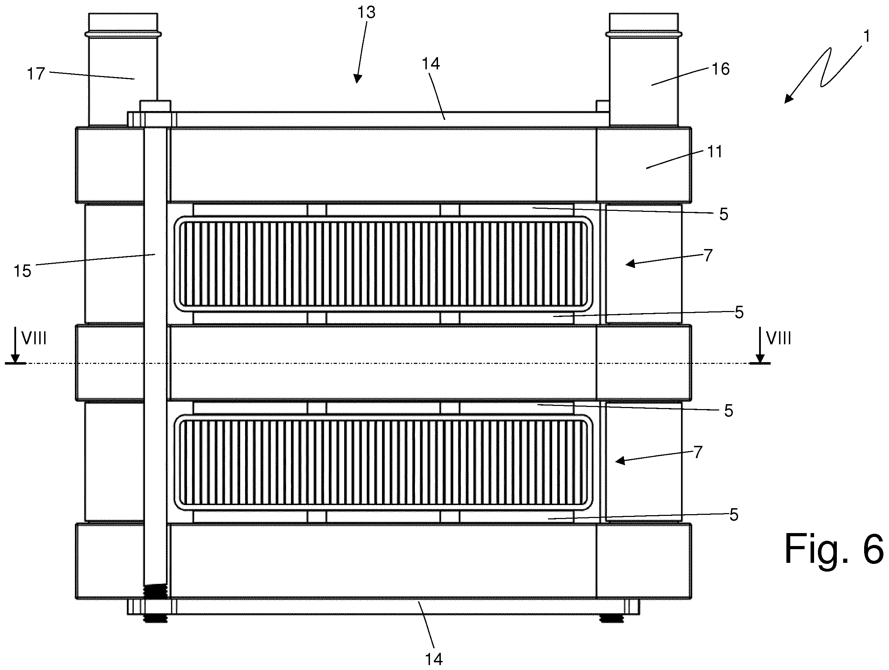

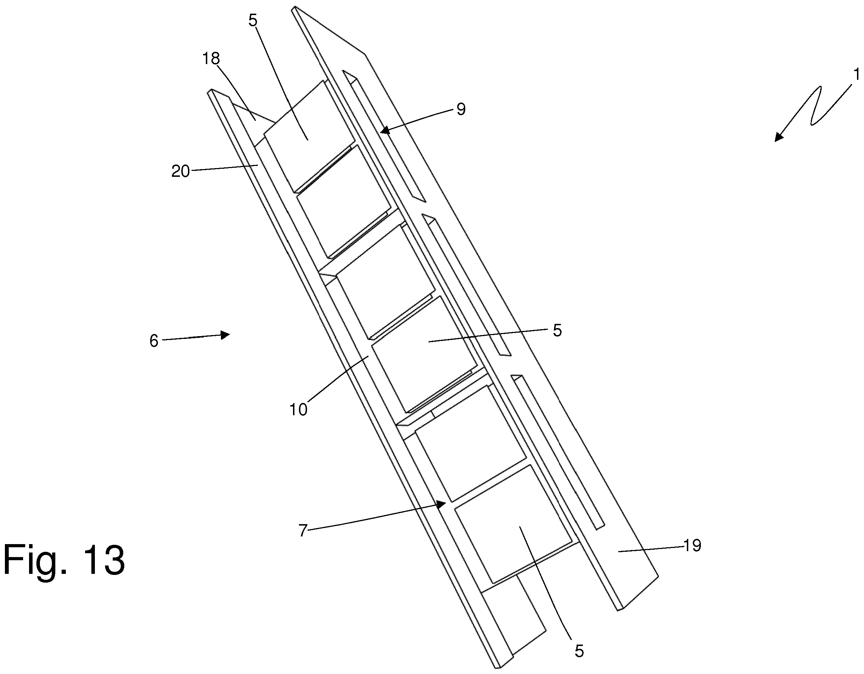

As better shown in Figure 6, the twelve thermoelectric cells 5 are divided into four groups, each made up of three adjacent thermoelectric cells 5. The embodiment shown in Figures 10-13 provides two superimposed feeding elements 6 (supporting a total of six ducts 7), three cooling elements 11 alternated with the two feeding elements 6 and twenty-four thermoelectric cells 5, each of which is interposed between a corresponding duct 7 of a feeding element 6 and a corresponding cooling element 11. As better shown in Figure 13, the twenty-four thermoelectric cells 5 are divided into four groups (only one of which being visible in Figure 13), each consisting of six adjacent thermoelectric cells 5.

According to other, and perfectly equivalent, embodiments, a different number of components are provided: for example, one/two/three/four feeding elements 6 could be provided (hence one/two/three/four ducts 7), two/three/four/five cooling elements 11, and from some units to some tens of thermoelectric cells 5, each of which is interposed between a corresponding duct 7 of a feeding element 6 and a corresponding cooling element 11.

The thermoelectric generator 1 described above has numerous advantages.

First, the thermoelectric generator 1 described above allows achieving a high energy efficiency in generating electric energy, as it allows a very high heat transmission from the exhaust gases flowing through the ducts 7 to the hot sides of the thermoelectric cells 5.

Moreover, the thermoelectric generator 1 described above is simple and inexpensive to manufacture, as it has a modular structure which allows choosing in an extremely simple way the number of thermoelectric cells 5 that are to be used (therefore varying the number of feeding elements 6 and the number of cooling elements 11).

In the thermoelectric generator 1 described above, the thermoelectric cells 5 are completely isolated from the exhaust gases, i.e. they are not touched by the exhaust gases, thus preserving the integrity of the thermoelectric cells 5. In fact, a direct contact of the exhaust gases with the thermoelectric cells 5 can damage the thermoelectric cells 5 both by thermal aggression (the exhaust gases may have a temperature higher than the maximum temperature tolerable by the thermoelectric cells 5) and by chemical aggression (in particular due to the oxidation favoured by high temperatures).

Finally, the thermoelectric generator 1 described above is particularly compact and light since the components (i.e. the walls 18 and 19 of the feeding elements 6) perform more functions with evident optimization. In particular, the walls 18 and 19 of the feeding elements 6 perform the structural function of supporting the ducts 7, perform the function of providing a stable and solid anchorage to the inlet pipe 2 and to the outlet pipe 3, perform the function of delimiting the casing 4, perform the function of protecting the thermoelectric cells 5 from the exhaust gases in that they prevent the exhaust gases from reaching the thermoelectric cells 5, and perform the function of channelling part of the heat possessed by the exhaust gases towards the ducts 7 and then towards the thermoelectric cells 5 (in other words, the ducts 7 are heated directly by the exhaust gases flowing along the ducts 7 and are indirectly heated by the exhaust gases transferring heat to the walls 18 and 19, which in turn transfer heat to the ducts 7).

## Claims

1. A thermoelectric generator (1) for an exhaust system of an internal combustion engine; the thermoelectric generator (1) comprising:
at least two superimposed feeding elements (6), each of which is provided with at least one duct (7) designed to be flown through by the exhaust gases, developing along a feeding direction between an inlet opening (8) and an outlet opening (9) and having at least one first heat exchange wall (10), which is parallel to the feeding direction;
at least one cooling element (11), which is designed to remove heat, is close to the duct (7) and has at least one second heat exchange wall (12), which is parallel to the first heat exchange wall (10) of a feeding element (6); and
at least one thermoelectric cell (5), which is interposed between the duct (7) and the cooling element (11) and has a hot side resting against the first heat exchange wall (10) of a feeding element (6) and a cold side resting against the second heat exchange wall (12);
wherein each feeding element (6) comprises a front wall (18), which is rigidly integral to the duct (7), is perpendicular to the duct (7) and to the first heat exchange wall (10) and has the central inlet opening (8); and
wherein each feeding element (6) comprises a rear wall (19), which is rigidly integral to the duct (7), is perpendicular to the duct (7) and to the first heat exchange wall (10), is parallel to the front wall (18) and has the central outlet opening (9);
the thermoelectric generator (1) being **characterized in that** an upper edge or a lower edge of the front wall (18) or of the rear wall (19) of each feeding element (6) is flared to provide a mechanical interlocking between the two superimposed feeding elements (6).

2. A thermoelectric generator (1) according to claim 1, wherein each feeding element (6) is H-shaped, wherein the front wall (18) and the rear wall (19) make up the two bars and the duct (7) makes up the connection portion between the two bars.

3. A thermoelectric generator (1) according to claim 1 or 2, wherein only the upper edge or, alternatively, only the lower edge of the front wall (18) or of the rear wall (19) of each feeding element (6) is flared so as to create a mechanical interlocking between the two superimposed feeding elements (6).

4. A thermoelectric generator (1) according to claim 1, 2 or 3, wherein in the front wall (18) or in the rear wall (19) of each feeding element (6) the flare provides a recess (20) formed by means of an S-shaped deformation in the corresponding upper edge or in the corresponding lower edge.

5. A thermoelectric generator (1) according to claim 4, wherein only in the front wall (18) or, alternatively, only in the rear wall (19) of each feeding element (6) the flare provides a recess (20) formed by means of an S-shaped deformation, whereas the rear wall (19) or, alternatively, the front wall (18) is completely flat and therefore lacking any recess and any S-shaped deformation.

6. A thermoelectric generator (1) according to claim 4 or 5, wherein:
in a first feeding element (6), the front wall (18) has a recess (20) formed by means of an S-shaped deformation and the rear wall (19) is completely flat, therefore lacking any S-shaped deformation;
and in a second feeding element (6), the rear wall (19) has a recess (20) formed by means of an S-shaped deformation and the front wall (18) is completely flat, therefore lacking any S-shaped deformation.

7. A thermoelectric generator (1) according to claim 4, 5, or 6, wherein:
the rear wall (19) or the front wall (18) of each feeding element (6) has a lower height than the front wall (18) or the rear wall (19) of the feeding element (6).

8. A thermoelectric generator (1) according to claim 7, wherein:
in a first feeding element (6), the front wall (18) has a lower height than the rear wall (19); and
in a second feeding element (6) the front wall (18) has a higher height than the rear wall (19).

9. A thermoelectric generator (1) according to any one of the claims from 1 to 8 and comprising a cooling system, which comprises, in turn:
the cooling element (11), which is designed to be flown through by a cooling fluid;
a delivery pipe (16), which is arranged beside the duct (7) and is hydraulically connected to the cooling element (11) so as to convey the cooling fluid towards the cooling element (11); and
a return pipe (17), which is arranged beside the duct (7) on the opposite side relative to the delivery pipe (16) and is hydraulically connected to the cooling element (11) so as to receive the cooling fluid from the cooling element (11) .

10. A thermoelectric generator (1) according to any one of the claims from 1 to 9, wherein:
it is provided a fixing system (13), which locks in a clamping manner each feeding element (6), the cooling element (11) and the thermoelectric cell (5); and
the fixing system (13) comprises a lower plate (14), an upper plate (14) and at least one pair of tie bars (15), which are perpendicular to the plates (14) and connect the plates (14).

11. A thermoelectric generator (1) according to any one of the claims from 1 to 10 and comprising:
two feeding elements (6) on top of one another;
three cooling elements (11), which are alternated with the two feeding elements (6); and
at least four thermoelectric cells (5), each interposed between a corresponding duct (7) and a corresponding cooling element (11).

12. A thermoelectric generator (1) according to any one of the claims from 1 to 11, wherein each feeding element (6) comprises different ducts (7), which are adjacent and separate.

13. A thermoelectric generator (1) according to claim 12 and comprising a fixing system (13), which locks in a clamping manner each feeding element (6), the cooling element (11) and the thermoelectric cell (5) and comprises a lower plate (14), an upper plate (14) and a plurality of tie bars (15), which are perpendicular to the plates (14) and connect the plates (14), wherein at least one tie bar (15) is arranged between two adjacent ducts (7).

14. A thermoelectric generator (1) according to any one of the claims from 1 to 13 and comprising at least one graphite sheet, which is interposed between one side of the thermoelectric cell (5) and a corresponding heat exchange wall (10, 12).

## Patentansprüche

1. Thermoelektrischer Generator (1) für ein Abgassystem eines Verbrennungsmotors; wobei der thermoelektrische Generator (1) umfasst:
wenigstens zwei übereinander angeordnete Zuführungselemente (6), von denen jedes mit wenigstens einem Kanal (7) versehen ist, der dafür konfiguriert ist, von Abgasen durchströmt zu werden und sich entlang einer Zuführungsrichtung zwischen einer Einlassöffnung (8) und einer Auslassöffnung (9) ausprägt und wenigstens eine erste Wärmeaustauschwand (10) aufweist, die parallel zur Zuführungsrichtung verläuft;
wenigstens ein Kühlelement (11), das zum Abführen von Wärme ausgebildet ist, sich in der Nähe des Kanals (7) befindet und wenigstens eine zweite Wärmeaustauschwand (12) aufweist, die parallel zur ersten Wärmeaustauschwand (10) eines Zuführungselements (6) verläuft; und
wenigstens eine thermoelektrische Zelle (5), die zwischen dem Kanal (7) und dem Kühlelement (11) angeordnet ist und eine heiße Seite aufweist, die an der ersten Wärmeaustauschwand (10) eines Zuführungselements (6) anliegt, sowie eine kalte Seite, die an der zweiten Wärmeaustauschwand (12) anliegt;
wobei jedes Zuführungselement (6) eine Vorderwand (18) umfasst, die starr in dem Kanal (7) integriert ist, senkrecht zu dem Kanal (7) und zu der ersten Wärmeaustauschwand (10) steht und die zentrale Einlassöffnung (8) aufweist; und
wobei jedes Zuführungselement (6) eine Rückwand (19) umfasst, die starr in dem Kanal (7) integriert ist, senkrecht zu dem Kanal (7) und zu der ersten Wärmeaustauschwand (10) steht, parallel zur Vorderwand (18) verläuft und die zentrale Auslassöffnung (9) aufweist;
wobei der thermoelektrische Generator (1) **dadurch gekennzeichnet ist, dass** eine Oberkante oder eine Unterkante der Vorderwand (18) oder der Rückwand (19) jedes Zuführungselements (6) ausgestellt ist, um eine mechanische Verflechtung zwischen den beiden übereinander angeordneten Zuführungselementen (6) zu schaffen.

2. Thermoelektrischer Generator (1) nach Anspruch 1, wobei jedes Zuführungselement (6) H-förmig ist, wobei die Vorderwand (18) und die Rückwand (19) die beiden Striche bilden und der Kanal (7) den Verbindungsabschnitt zwischen den beiden Strichen bildet.

3. Thermoelektrischer Generator (1) nach Anspruch 1 oder 2, wobei nur die Oberkante oder, alternativ, nur die Unterkante der Vorderwand (18) oder der Rückwand (19) jedes Zuführungselements (6) ausgestellt ist, um eine mechanische Verflechtung zwischen den beiden übereinander angeordneten Zuführungselementen (6) zu schaffen.

4. Thermoelektrischer Generator (1) nach Anspruch 1, 2 oder 3, wobei in der Vorderwand (18) oder in der Rückwand (19) jedes Zuführungselements (6) die Ausstellung eine Vertiefung (20) schafft, die durch eine S-förmige Verformung in der entsprechenden Oberkante oder in der entsprechenden Unterkante ausgebildet wird.

5. Thermoelektrischer Generator (1) nach Anspruch 4, wobei nur in der Vorderwand (18) oder, alternativ, nur in der Rückwand (19) jedes Zuführungselements (6) die Ausstellung eine mittels einer S-förmigen Verformung ausgebildete Vertiefung (20) schafft, während die Rückwand (19) oder, alternativ, die Vorderwand (18) völlig eben ist und somit keine Vertiefung und keine S-förmige Verformung aufweist.

6. Thermoelektrischer Generator (1) nach Anspruch 4 oder 5, wobei:
in einem ersten Zuführungselement (6) die Vorderwand (18) eine mittels einer S-förmigen Verformung ausgebildete Vertiefung (20) aufweist und die Rückwand (19) völlig eben ist und somit keine S-förmige Verformung aufweist;
und in einem zweiten Zuführungselement (6) die Rückwand (19) eine mittels einer S-förmigen Verformung ausgebildete Vertiefung (20) aufweist und die Vorderwand (18) völlig eben ist und somit keine S-förmige Verformung aufweist.

7. Thermoelektrischer Generator (1) nach Anspruch 4, 5 oder 6, wobei:
die Rückwand (19) oder die Vorderwand (18) jedes Zuführungselements (6) eine niedrigere Höhe aufweist als die Vorderwand (18) oder die Rückwand (19) des Zuführungselements (6).

8. Thermoelektrischer Generator (1) nach Anspruch 7, wobei:
in einem ersten Zuführungselement (6) die Vorderwand (18) eine niedrigere Höhe als die Rückwand (19) aufweist; und
in einem zweiten Zuführungselement (6) die Vorderwand (18) eine höhere Höhe als die Rückwand (19) aufweist.

9. Thermoelektrischer Generator (1) nach einem der Ansprüche 1 bis 8, der ein Kühlsystem umfasst, welches wiederum umfasst:
das Kühlelement (11), das dazu ausgelegt ist, von einem Kühlfluid durchströmt zu werden;
eine Zulaufleitung (16), die neben dem Kanal (7) angeordnet und hydraulisch mit dem Kühlelement (11) verbunden ist, um das Kühlfluid zum Kühlelement (11) zu fördern; und
eine Rücklaufleitung (17), die neben dem Kanal (7) auf der der Zulaufleitung (16) gegenüberliegenden Seite angeordnet ist und hydraulisch mit dem Kühlelement (11) verbunden ist, um das Kühlfluid von dem Kühlelement (11) aufzunehmen.

10. Thermoelektrischer Generator (1) nach einem der Ansprüche von 1 bis 9, wobei:
ein Befestigungssystem (13) vorgesehen ist, das jedes Zuführungselement (6), das Kühlelement (11) und die thermoelektrische Zelle (5) klemmend befestigt; und
das Befestigungssystem (13) eine untere Platte (14), eine obere Platte (14) und wenigstens ein Paar Zugstäbe (15) umfasst, die senkrecht zu den Platten (14) stehen und die Platten (14) verbinden.

11. Thermoelektrischer Generator (1) nach einem der Ansprüche von 1 bis 10, umfassend:
zwei übereinander angeordnete Zuführungselemente (6);
drei Kühlelemente (11), die mit den beiden Zuführungselementen (6) abwechselnd angeordnet sind; und
wenigstens vier thermoelektrische Zellen (5), die jeweils zwischen einem entsprechenden Kanal (7) und einem entsprechenden Kühlelement (11) angeordnet sind.

12. Thermoelektrischer Generator (1) nach einem der Ansprüche von 1 bis 11, wobei jedes Zuführungselement (6) verschiedene Kanäle (7) umfasst, die benachbart und getrennt sind.

13. Thermoelektrischer Generator (1) nach Anspruch 12, ein Befestigungssystem (13) umfassend, das jedes Zuführungselement (6), das Kühlelement (11) und die thermoelektrische Zelle (5) klemmend befestigt und eine untere Platte (14), eine obere Platte (14) und mehrere Zugstäbe (15) umfasst, die senkrecht zu den Platten (14) stehen und die Platten (14) verbinden, wobei wenigstens ein Zugstab (15) zwischen zwei benachbarten Kanälen (7) angeordnet ist.

14. Thermoelektrischer Generator (1) nach einem der Ansprüche von 1 bis 13, wenigstens eine Graphitscheibe umfassend, die zwischen einer Seite der thermoelektrischen Zelle (5) und einer entsprechenden Wärmeaustauschwand (10, 12) angeordnet ist.

## Revendications

1. Générateur thermoélectrique (1) pour un système d'échappement d'un moteur à combustion interne ; le générateur thermoélectrique (1) comprenant :
au moins deux éléments d'alimentation (6) superposés, dont chacun est prévu avec au moins un conduit (7) conçu pour que les gaz d'échappement s'écoulent à travers ce dernier, se développant le long d'une direction d'alimentation entre une ouverture d'entrée (8) et une ouverture de sortie (9) et ayant au moins une première paroi d'échange de chaleur (10) qui est parallèle à la direction d'alimentation ;
au moins un élément de refroidissement (11) qui est conçu pour retirer la chaleur, est à proximité du conduit (7) et a au moins une seconde paroi d'échange de chaleur (12) qui est parallèle à la première paroi d'échange de chaleur (10) d'un élément d'alimentation (6) ; et
au moins une cellule thermoélectrique (5) qui est intercalée entre le conduit (7) et l'élément de refroidissement (11) et a un côté chaud s'appuyant contre la première paroi d'échange de chaleur (10) d'un élément d'alimentation (6) et un côté froid s'appuyant contre la seconde paroi d'échange de chaleur (12) ;
dans lequel chaque élément d'alimentation (6) comprend une paroi avant (18), qui est rigidement solidaire avec le conduit (7), est perpendiculaire au conduit (7) et à la première paroi d'échange de chaleur (10) et a l'ouverture d'entrée centrale (8) ; et
dans lequel chaque élément d'alimentation (6) comprend une paroi arrière (19) qui est rigidement solidaire avec le conduit (7), est perpendiculaire au conduit (7) et à la première paroi d'échange de chaleur (10), est parallèle à la paroi avant (18) et a l'ouverture de sortie centrale (9) ;
le générateur thermoélectrique (1) étant **caractérisé en ce qu'**un bord supérieur ou un bord inférieur de la paroi avant (18) ou de la paroi arrière (19) de chaque élément d'alimentation (6) est évasé pour fournir un verrouillage mécanique entre les deux éléments d'alimentation (6) superposés.

2. Générateur thermoélectrique (1) selon la revendication 1, dans lequel chaque élément d'alimentation (6) est en forme de H, dans lequel la paroi avant (18) et la paroi arrière (19) composent les deux barres et le conduit (7) compose la partie de raccordement entre les deux barres.

3. Générateur thermoélectrique (1) selon la revendication 1 ou 2, dans lequel seul le bord supérieur ou en variante seul le bord inférieur de la paroi avant (18) ou de la paroi arrière (19) de chaque élément d'alimentation (6) est évasé afin de créer un verrouillage mécanique entre les deux éléments d'alimentation (6) superposés.

4. Générateur thermoélectrique (1) selon la revendication 1, 2 ou 3, dans lequel dans la paroi avant (18) ou dans la paroi arrière (19) de chaque élément d'alimentation (6), l'évasement fournit un évidement (20) formé au moyen d'une déformation en forme de S dans le bord supérieur correspondant ou dans le bord inférieur correspondant.

5. Générateur thermoélectrique (1) selon la revendication 4, dans lequel uniquement dans la paroi avant (18) ou en variante uniquement dans la paroi arrière (19) de chaque élément d'alimentation (6), l'évasement fournit un évidement (20) formé au moyen d'une déformation en forme de S, dans lequel la paroi arrière (19) ou en variante la paroi avant (18) est complètement plate et par conséquent dépourvue de tout évidement et de toute déformation en forme de S.

6. Générateur thermoélectrique (1) selon la revendication 4 ou 5, dans lequel :
dans un premier élément d'alimentation (6), la paroi avant (18) a un évidement (20) formé au moyen d'une déformation en forme de S et la paroi arrière (19) est complètement plate, par conséquent dépourvue de toute déformation en forme de S ;
et dans un second élément d'alimentation (6), la paroi arrière (19) a un évidement (20) formé au moyen d'une déformation en forme de S et la paroi avant (18) est complètement plate, par conséquent dépourvue de toute déformation en forme de S.

7. Générateur thermoélectrique (1) selon la revendication 4, 5 ou 6, dans lequel :
la paroi arrière (19) ou la paroi avant (18) de chaque élément d'alimentation (6) a une hauteur plus basse que la paroi avant (18) ou que la paroi arrière (19) de l'élément d'alimentation (6).

8. Générateur thermoélectrique (1) selon la revendication 7, dans lequel :
dans le premier élément d'alimentation (6), la paroi avant (18) a une hauteur plus basse que la paroi arrière (19) ; et
dans un second élément d'alimentation (6), la paroi avant (18) a une hauteur plus haute que la paroi arrière (19).

9. Générateur thermoélectrique (1) selon l'une quelconque des revendications 1 à 8 et comprenant un système de refroidissement qui comprend à son tour :
l'élément de refroidissement (11) qui est conçu pour qu'un fluide de refroidissement s'écoule à travers ce dernier ;
un tuyau de distribution (16) qui est agencé derrière le conduit (7) et est raccordé fluidiquement à l'élément de refroidissement (11) afin de transporter le fluide de refroidissement vers l'élément de refroidissement (11) ; et
un tuyau de retour (17) qui est agencé à côté du conduit (7) sur le côté opposé par rapport au tuyau de distribution (16) et est raccordé fluidiquement à l'élément de refroidissement (11) afin de recevoir le fluide de refroidissement de l'élément de refroidissement (11).

10. Générateur thermoélectrique (1) selon l'une quelconque des revendications 1 à 9, dans lequel :
il est prévu un système de fixation (13) qui bloque, par serrage, chaque élément d'alimentation (6), l'élément de refroidissement (11) et la cellule thermoélectrique (5) ; et
le système de fixation (13) comprend une plaque inférieure (14), une plaque supérieure (14) et au moins une paire de tirants (15) qui sont perpendiculaires aux plaques (14) et raccordent les plaques (14).

11. Générateur thermoélectrique (1) selon l'une quelconque des revendications 1 à 10 et comprenant :
deux éléments d'alimentation (6) l'un sur le dessus de l'autre ;
trois éléments de refroidissement (11) qui sont alternés avec les deux éléments d'alimentation (6) ; et
au moins quatre cellules thermoélectriques (5), chacune intercalée entre un conduit (7) correspondant et un élément de refroidissement (11) correspondant.

12. Générateur thermoélectrique (1) selon l'une quelconque des revendications 1 à 11, dans lequel chaque élément d'alimentation (6) comprend des conduits (7) différents qui sont adjacents et séparés.

13. Générateur thermoélectrique (1) selon la revendication 12 et comprenant un système de fixation (13) qui bloque, par serrage, chaque élément d'alimentation (6), l'élément de refroidissement (11) et la cellule thermoélectrique (5) et comprend une plaque inférieure (14), une plaque supérieure (14) et une pluralité de tirants (15) qui sont perpendiculaires aux plaques (14) et raccordent les plaques (14), dans lequel au moins un tirant (15) est agencé entre deux conduits (7) adjacents.

14. Générateur thermoélectrique (1) selon l'une quelconque des revendications 1 à 13, et comprenant au moins une feuille de graphite, qui est intercalée entre un côté de la cellule thermoélectrique (5) et une paroi d'échange de chaleur (10, 12) correspondante.
